# EUROPEAN PATENT APPLICATION

(11) **EP 1 887 104 A2**
(43) Date of publication of application: **13.02.2008**
(21) Application number: 07253067.8
(22) Date of filing: 03.08.2007
(51) Int. Cl.: C23C 16/40, C23C 16/448, C23C 16/455

(54) **Radical assisted batch film deposition**

(30) Priority: 03.08.2006 US 821308 P
(71) Applicant: Aviza Technology, Inc., Scotts Valley, CA 95066 (US)
(72) Inventor: Treichel, Helmuth, Milpitas, CA 95035 (US); Qiu, taiquing Thomas, Los gatos, CA 95032 (US); Bailey, Robert Jeffrey, Scotts Valley, CA 95066 (US)
(74) Representative: Dunlop, Brian Kenneth Charles

(57) **Abstract**

A process for radical assisted film deposition simultaneously on multiple wafer substrates (16) is provided. The multiple wafer substrates (16) are loaded into a reactor (12) that is heated to a desired film deposition temperature. A stable species source of oxide or nitride counter ion is introduced into the reactor. An *in situ* radical generating reactant is also introduced into the reactor along with a cationic ion deposition source. The cationic ion deposition source is introduced for a time sufficient to deposit a cationic ion-oxide or a cationic ion-nitride film simultaneously on multiple wafer substrates. Deposition temperature is below a conventional chemical vapor deposition temperature absent the *in situ* radical generating reactant. A high degree of wafer-to-wafer uniformity among the multiple wafer substrates is obtained by introducing the reactants through elongated vertical tube injectors (22) having vertically displaced orifices (30), injectors surrounded by a liner having vertically displaced exhaust ports to impart across flow of movement of reactants simultaneously across the multiple wafer substrates. With molecular oxygen as a stable species source of oxide, and hydrogen as the *in situ* radical generating reactant, oxide films of silicon are readily produced with a silicon-containing precursor introduced into the reactor.

## Description

### CROSS-REFERENCE TO RELATED APPLICATIONS

This application claims priority of United States Provisional Patent Application Serial No. 60/821,308 filed August 3, 2006, which is incorporated herein by reference.

### FIELD OF THE INVENTION

The present invention in general relates to an integrated circuit film deposition simultaneously on multiple wafer substrates and in particular to the use of radical assisted oxide or nitride deposition to decrease film deposition temperature.

### BACKGROUND OF THE INVENTION

Chemical vapor deposition (CVD) is a process widely used in semiconductor device manufacturing to produce uniform insulating films. The goal of conventional CVD using radicals involves shallow trench filling with films formed for example from reactions such as tetraethyloxysilane (TEOS) reacted with ozone. Alternatively, various silane precursors are reacted with oxygen to form insulating spacers needed around transistor electrodes. While the reaction of silane precursors with oxygen radicals such as ozone and the associated equilibrium producing singlet oxygen affords several benefits in terms of processing conditions and the resultant silicon oxide films produced, unfortunately ozone is unstable at the elevated temperatures associated with deposition from numerous silicon precursors. As a result, conventional TEOS/ozone reaction requires a high degree of control to assure uniform distribution of reactive oxygen species to produce uniform oxide films so as to prevent the gas phase silica particle formation. The extent of control that must be exerted over ozone decomposition has resulted in successful film deposition from silicon precursors reacting with ozone occurring only in single wafer reaction chambers. While it is widely recognized that mass production of microelectronics would benefit from a batch CVD deposition process involving ozone or other radical precursors, attempts to control the decomposition of ozone and other radicals so as to obtain uniform distribution of reactive atomic species over large diameter wafer surfaces and throughout a wafer stack has met with limited success.

While substitution of molecular oxygen for ozone is known to proceed to form high quality conformal oxide films with silicon precursors that largely overcomes the difficulties associated with operating with ozone, such reactions typically require wafer temperatures above 650°C. The wafer deposition temperatures associated with oxide deposition from a silicon precursor and oxygen reaction have limited the applicability of this reaction owing to thermal bulge limitations to prevent dopant diffusion in devices.

The formation of nitride films typically occurs through the reaction of the precursor with ammonia at elevated temperature to produce silicon nitride. By analogy to oxide film formation, the reaction temperature required to react a precursor with ammonia tends to occur at elevated temperatures that preclude silicon nitride formation in numerous instances. Alternatively, the use of a plasma source or an unstable nitrogen-containing compound such as hydrazine have been attempted, yet met with limited success owing to the difficulties associated with maintaining process uniformity to assure uniform film growth across a wafer substrate. As a result, such processes have been limited to single wafer CVD.

Thus, there exists a need for a radical assisted batch film deposition process-Additionally, there exists a need for a process capable of producing high quality conformal oxide and nitride films at a lower temperature than that associated with conventional processes.

### SUMMARY OF THE INVENTION

A process for radical assisted film deposition simultaneously on multiple wafer substrates is provided. The multiple wafer substrates are loaded into a reactor that is heated to a desired film deposition temperature. A stable species source of oxide or nitride counter ion is introduced into the reactor. An *in situ* radical generating reactant is also introduced into the reactor along with a cationic ion deposition source. The cationic ion deposition source is introduced for a time sufficient to deposit a cationic ion-oxide or a cationic ion-nitride film simultaneously on multiple wafer substrates. Deposition temperature is below a conventional chemical vapor deposition temperature absent the *in situ* radical generating reactant. A high degree of wafer-to-wafer uniformity among the multiple wafer substrates is obtained by introducing the reactants through elongated vertical tube injectors having vertically displaced orifices, injectors surrounded by a liner having vertically displaced exhaust ports to impart across flow of movement of reactants simultaneously across the multiple wafer substrates. With molecular oxygen as a stable species source of oxide, and hydrogen as the *in situ* radical generating reactant, oxide films of silicon are readily produced with a silicon-containing precursor introduced into the reactor.

### BRIEF DESCRIPTION OF THE DRAWINGS

FIG. 1 is a cross-sectional view of a batch reactor operative with the present invention to perform radical assisted film formation;

FIG. 2 is a perspective view of an interior portion of a reaction chamber depicted in FIG. 1;

FIG. 3 is a schematic view of an alternate gas inlet arrangement for performance of an inventive process;

FIG. 4 is a schematic flowchart diagram of an inventive process; and

FIG. 5 is a schematic of an alternate process for performing an inventive process.

### DETAILED DESCRIPTION OF THE PREFERRED EMBODIMENTS

The present invention has utility as a process for the deposition of oxide and/or nitride films simultaneously on multiple semiconductor wafer substrates. *In situ* radical formation in a uniform manner throughout a reaction volume allows for batch CVD deposition. The present invention in addition to achieving film deposition in a batch process, also affords several process condition advantages over the prior art illustratively including properties such as conformality, wafer deposition temperature, successive disparate layer deposition, and reagent handling.

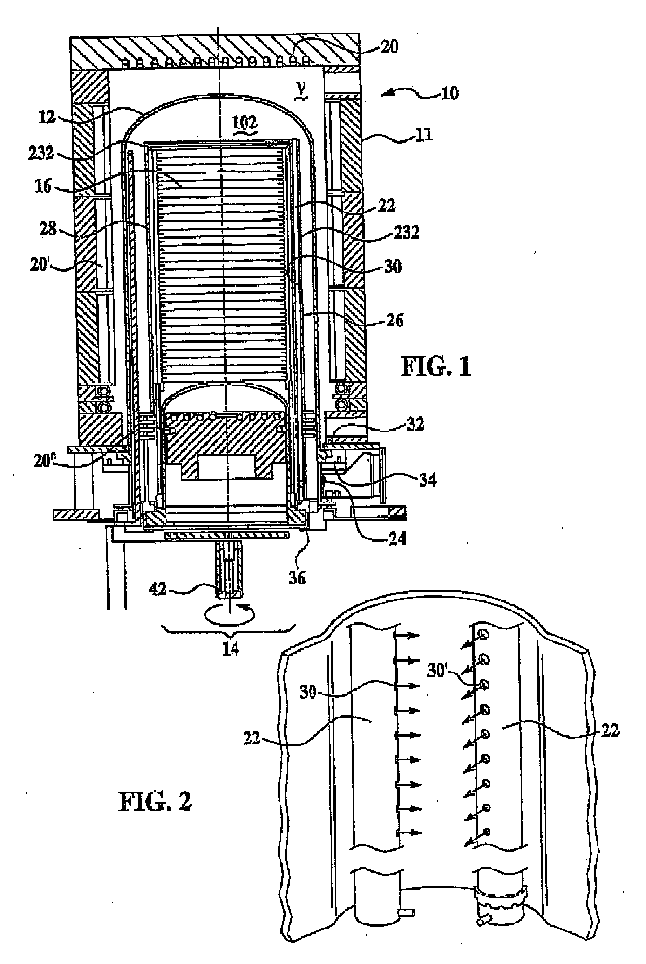

In order to overcome prior difficulties associated with uniform precursor distribution within a batch chamber, a chamber is utilized inclusive of a liner having a series of exhaust ports and surrounding elongated reactant injector tubes, each rotatable about a tube axis with the tubes including orifices in registry with wafer carrier positions. The result of reactant flow from tubes flowing towards liner exhaust ports creates a flow across the multiple wafer surfaces in a laminar flow pattern. Such a reactor is disclosed in WO 2005/031233 filed September 22, 2004. Such a reactor is currently commercially available from Aviza Technology (Scotts Valley, CA) under the trade names RVP 550 and Verano 5500. Referring now to FIGS. 1-3, a representative reactor suitable for providing uniform distribution of precursors within a batch reactor chamber is depicted generally at 10.

A vessel 11 that encloses a volume V to form a process chamber 12 having a support 14 adapted for receiving a batch wafer carrier 16 having a number of heating elements, 20, 20', 20" (referred to collectively hereinafter as heating elements 112) for raising a temperature of a wafer batch on the carrier 16 to the desired temperature for thermal processing. The reactor 10 optionally includes one or more optical or electrical temperature sending elements, such as a thermocouple (T/C), for monitoring the temperature within the process chamber 12 and controlling operation of the heating elements 20-20". Thermal uniformity is thereby achieved along the vertical extent of the carrier 16 when disposed within the process chamber 12. The reactor 10 includes two or more injectors 22, 22', and 22" for *in situ* introducing a precursor in the form of a gas or vapor into the process chamber 12 for the deposition of an oxide or nitride film simultaneously on the multiple wafers through a radical generated CVD process. It is appreciated that purge gases are also optionally supplied to the process chamber 12 via any or all of the injectors 22-22". A purge vent 24 is provided for exhausting the process chamber 12. A liner 26 includes slots 28 preferably in registry with wafer surfaces within a carrier 16 and orifices 30-30" of injectors 22-22" as denoted by the fluid flow arrows.

Generally, the vessel 11 has a seal, such as an O-ring 32, to a base-plate 34.

Openings for the injectors 22-22' are shown at 36, T/Cs and vents are sealed with O-rings, VCR®, or CF® fittings. Fluids released or deposition byproducts created during processing are evacuated through a foreline or exhaust port 42 formed in a wall of the process chamber 12 or in a plenum of the support 14. The process chamber 12 is operated at a pressure between 0.1 millitor and atmospheric at a variety of temperatures ranging from 100°C to 900°C. The reactor 10 is equipped with a pumping system illustratively including a roughing pump; a blower; a hi-vacuum pump; and roughing-, throttle-, and foreline-valves.

The vessel 11 and liner 26 are made of a variety of materials illustratively including metal, ceramic, crystalline or amorphous material that is capable of withstanding the thermal and mechanical stresses of high-temperature and high-vacuum operation, and which is resistant to erosion from gases and vapors used or released during processing. Preferably, the vessel 11 and liner 26 are made from an opaque, translucent, or transparent quartz glass having a sufficient thickness to withstand the mechanical stresses of the thermal processing operation and resist deposition of process byproducts.

Wafers in the carrier 16 are introduced into the reactor 10 through a load lock or loadport (not shown) and then into the process chamber 12 through an opening in the base-plate 34 capable of forming a gas-tight seal therewith. In the configuration shown in FIG. 1, the process chamber 12 is a vertical reactor and the access utilizes the movable support 14 that is raised during processing to seal with the base-plate 34, and lowered to enable an operator or an automated handling system, such as a boat handling unit (BHU) (not shown), to position the carrier 16 on the support 14.

The reactor 10 optionally also includes a wafer rotation system 42 that rotates the support 14 and the carrier 16 during processing. Rotating the carrier 16 during processing improves within wafer uniformity by averaging out any non-uniformities in temperature and process gas flow to create a uniform wafer temperature and species reaction profile. Generally, the wafer rotation system 42 is capable of rotating at a speed of from about 0.1 to about 10 revolutions per minute (RPM).

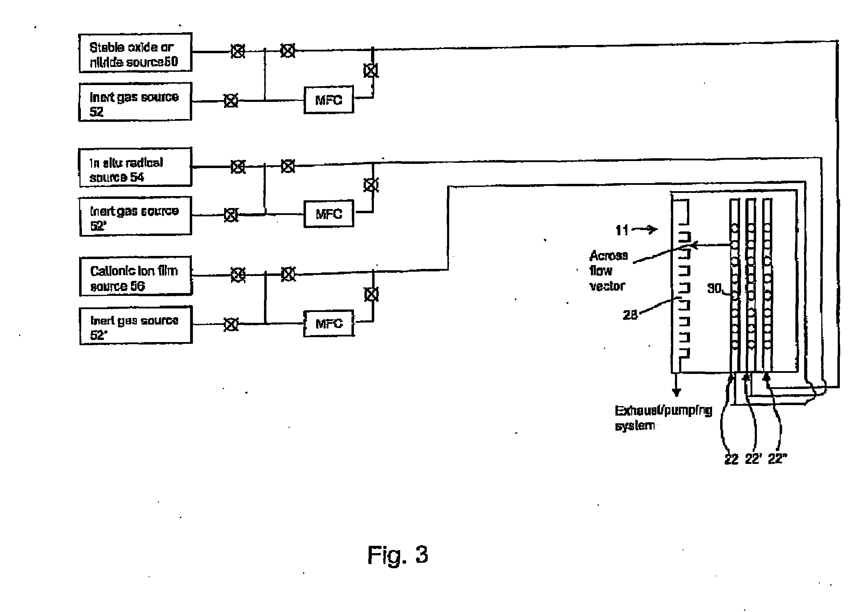

As depicted in FIG. 2, two injectors 22 and 22' are provided for the delivery of precursors for *in situ* radical formation to deposit an oxide or nitride simultaneously on a batch of wafers within a reactor 10. Similarly, in FIG. 3, three such injectors 22-22'' are provided. Preferably, an orifice 30 is in registry with wafer surfaces held in position by the wafer carrier 16 as well as with exhaust ports 28 provided in a liner 26 so as to provide a laminar across flow so as to uniformly deposit oxide or nitride films according to the present invention. As depicted in FIG. 2, the relative area of orifices 30' optionally vary along the length of the injector 22' in order to account for a pressure drop associated with emission from orifices in closer proximity to an inlet fluid source. Additionally, as shown with reference to injector 22-22', the relative diameter of injectors, and the angle defined between a radius of the wafer carrier 16 through the axis of an injector and the vector extending from an injector axis through an emission orifice are independently variable. With regard to the gas emission angle so defined, any angular value is available as each injector is independently rotatable around a longitudinal axis and fixed in a particular rotational orientation prior to introduction of a gas or vapor into an injector 22-22". Preferably, each injector is rotatable 360 degrees about the injector longitudinal axis. An indexing pin 45 associated with an injector identifies the angular position relative to an aperture in which it seats within the reactor 10. It is appreciated that other mechanisms are known to the art for selective rotation and positional locking of an injector relative to a reactant supply. These members illustratively include a collar.

An exemplary gas flow schematic for a three injector reactor is depicted in FIG. 3. A stable species source of an oxide or nitride counter ion 50 is provided in fluid communication with injector 22 within vessel 11. An inert gas source is optionally interconnected to injector 22. With the use of conventional valves a mass flow controller (MFC) both source 50 and 52, or either source alone are selectively fed to the vessel 11 by injector 22. With registry of a wafer surface and an exhaust slot, an across flow of reactants with a high degree of uniformity on a given wafer surface and vertically displaced wafers is achieved. In a similar manner, an *in situ* radical generating reactant source 54 alone, an inert gas source 52', or a combination thereof are selectively metered to injector 22'. Likewise, a cationic ion deposition source 56 alone, an inert gas source 52", or a combination thereof are selectively metered to injector 22". It is appreciated that with conventional gas connection schemes, inert gas sources 52' and 52", each independently is supplied by inert gas source 52. It is further appreciated that flowing inert gas through an injector when a reactant is not being provided through that injector tends to inhibit backflow into the unused injector.

Inventive embodiments inclusive of only two injectors 22 and 22', gas feed interconnection is provided for the cationic ion deposition source 56 and one of: the stable counter ion source 50 or the *in situ* radical source 54. Inert gas is supplied simultaneously and or separately from a reactant.

An inventive process for film deposition assisted by *in situ* radical formation simultaneously on multiple wafer substrates includes loading multiple wafers within a reactor and purging the reactor with an inert fluid and evacuating the reactor. It is appreciated that the reactor is either maintained at deposition temperature prior to a wafer stack loaded and a wafer carrier being loaded therein, or alternatively, the reactor is brought to deposition temperature subsequent to evacuation.

Thereafter, the chamber pressure is stabilized at the desired value with an inert fluid and a stable species source of oxide ions or nitride ions is introduced.

A stable species source as used herein as defined to include a molecule thermodynamically dominant equilibrium to related species at a deposition temperature.

Representative stable oxide species sources include molecular oxygen, carbon monoxide, nitrous oxide, nitric oxide and water. Stable nitride species sources operative herein illustratively include molecular nitrogen, ammonia, and N₂H₄. With the stable species source flowing within the batch reactor, an *in situ* radical generating reactant is introduced into the reactor. It is appreciated that the stable species source and the *in situ* radical generating reactant are introduced sequentially in either order, or simultaneously within the reactor volume. Representative *in situ* radical generating reactants operative herein illustratively include molecular hydrogen, deuterium, oxygen, ammonia, and combinations thereof. It is noted that the *in situ* radical generating reactant is itself a thermodynamically stable form at deposition temperature yet reacts with the stable species source at deposition temperatures to form *in situ* radicals that facilitate film deposition.

It is appreciated that the addition of two or more *in situ* radical generating reactants is noted to impact the deposition rate and quality of the resultant film based on parameters including order of introduction, stoichiometry of radical generating reactants, stoichiometry of plural radical generating reactants relative to stable species source for a given constant reactor pressure and deposition temperature. By way of example, and without intending to be limited to a particular theory, the deposition rate of silicon nitride from SiH₄ as a cationic deposition ion source reacted with a stable species source of ammonia and an *in situ* radical generating reactant of hydrogen is improved by the inclusion of O₂. Particular improvement in film deposition occurs at relative molar ratios of 0.1-10:1 H₂:O₂. Still further improvement is noted when dinitrogen oxide is introduced into the reactor in concert with hydrogen. Silicon nitride deposition is noted to proceed at <450°C and a total reactor pressure of from 50 mT to 10 T according to the present invention with these conditions being desirable as compared to plasma assisted or conventional CVD processes as well as the fact that such deposition occurs simultaneously on multiple wafer substrates in a batch reactor.

Stable oxide or nitride ion source, and an *in situ* radical generating source are allowed while within the reactor and in contact with the multiple wafer surfaces for a time typically ranging from 0 to 2000 seconds prior to introduction of a cationic deposition source. It is appreciated that a single injector can be used for the simultaneous or sequential delivery of multiple reactants or inert gases. Preferably, to assure only *in situ* radical generation within the reactor, as opposed to within an injector, the stable oxide or nitride ion source is not delivered from the same injector as an *in situ* radical generating species.

Cationic ion deposition sources operative within the present invention are virtually unlimited and dependent only upon the nature of the cationic ion being incorporated within a film, wafer deposition temperature, and deposition byproduct volatility. Oxides and nitrides are formed from a variety of cationic ions illustratively including silicon, tantalum, aluminum, titanium, niobium, zirconium, hafnium, zinc, manganese, tin, indium, tungsten, and gallium. Specific cationic ion deposition sources operative herein include TEOS, trisilylamine (TSA), hexamethyldislane; trimethyl gallium; tantalum pentachloride; trimethyl aluminum, aluminum trichloride; titanium tetrachloride; titanium tetraoxide; niobium pentachloride; zirconium tetrachloride; hafnium tetrachloride; zinc dichloride; molybdenum hexafluoride, molybdenum pentachloride; magnesium dichloride; tin tetrachloride; indium trichloride, trimethyl indium; tungsten hexafluoride; and amidocomplexes of mentioned elements (e.g., tetakis-dimethylamido hafnium (TDMAHf)).

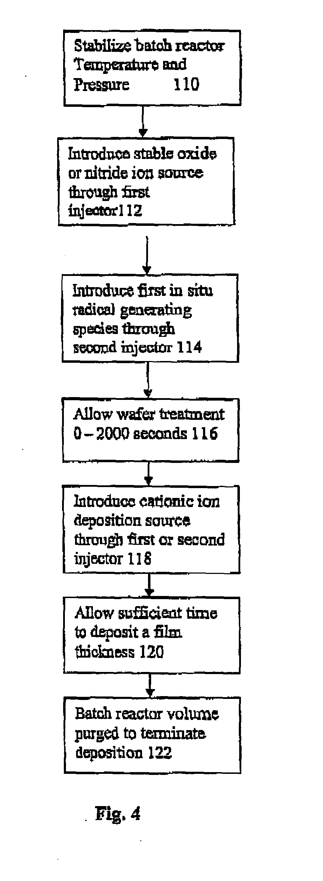

Referring now to FIG. 4, a schematic of an inventive process is provided. Temperature and pressure within a batch reactor loaded with a wafer carrier including multiple wafers is stabilized at step 110. Temperature stabilization is performed through use of heating elements and feedback control with temperature sensors dispersed within the reactor. Pressure stabilization results after reactor evacuation and backfill with an inert fluid. Depending on the nature of the film deposited, inert fluids illustratively include nitrogen, helium, and argon. Typically, the temperature is stabilized between ambient and 900°C although most film depositions of commercial interest occur between 400°C and 800°C and preferably between 400°C and 700°C. Pressure stabilization typically occurs between 1 milliTorr and 100 Torr with most film deposition reactions of commercial interest occurring between 50 milliTorr and 10 Torr.

A stable oxide or nitride ion source is introduced into the batch reactor through an injector 112, The introduced stable oxide or nitride ion source flows across vertically displaced wafer substrates within the batch reactor. In concert with or subsequent to step 112, *in situ* radical generating source(s) are introduced into the reactor 114. Preferably, the *in situ* radical generating species is delivered to the reactor through an injector different than that used to provide stable oxide or nitride ion source to the reactor. In the instances where multiple *in situ* radical generating sources are provided, such sources are provided in concert or in sequence.

The wafer substrates within the batch reactor are allowed to remain in contact with the *in situ* generated radicals for a time of between 0 and 2000 seconds at step 116. The cationic ion deposition source is then introduced into the batch reactor at step 118 by way of an across-flow positioned injector. Wafer-to-wafer thickness variations among a batch of 100 wafers of less than 5 thickness percent are routinely noted and typically less than 3 thickness percent. After allowing sufficient time to deposit a film thickness at step 120, the batch reactor volume is purged to terminate deposition at step 122.

It is appreciated that the process sequence depicted in FIG. 4 is amenable to depositing a film having a variety of thicknesses. As a result, an inventive process is operative in an atomic layer deposition (ALD) mode, as well as a bulk CVD mode. Additionally, owing to the inherent inefficiencies of batch processing, the inventive process is particularly well suited for repetition to successfully deposit layers of like or dissimilar composition film on the wafer substrates.

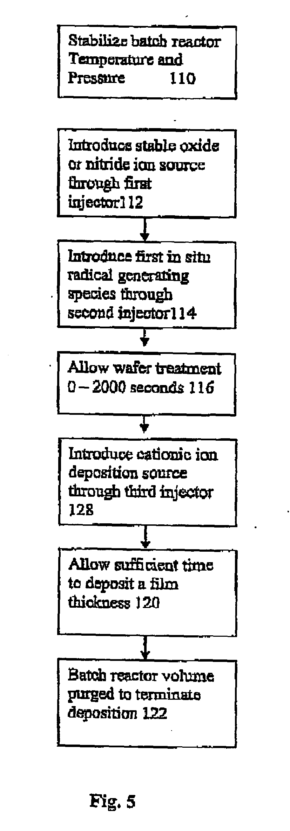

FIG. 5 depicts an alternate deposition process where like numerals correspond to those detailed above with respect to FIG. 4. The stabilized batch reactor at step 110 then receives a stable oxide or nitride ion source 112. In *situ* radical generating source(s) are introduced at step 114 and allowed to interact with a wafer substrate 116. A cationic ion deposition source is then introduced through a third injector, as depicted at 22" in FIG. 3, at step 128. After allowing sufficient time to deposit a film thickness 120, the batch reactor chamber is purged at step 122.

The present invention is further detailed with respect to the following non-limiting examples.

### EXAMPLE 1

### SiH₄ + O₂ + H₂ Oxide Deposition

A stack of wafers are loaded into a wafer carrier introduced into a reactor as detailed with respect to FIGS. 1 and 2. The process temperature of 700°C is maintained while the reactor has an internal oxygen concentration of less than 10 parts per million and is continuously purged by nitrogen gas. The reactor is evacuated to a base pressure of 30 milliTorr with multiple pumping stages that provide slower pumping at higher pressures and faster pumping as lower internal pressures are obtained. Upon stabilizing the pressure at 30 milliTorr, the gate valve is closed and a chamber leak check is performed. Nitrogen gas is flowed into the reactor to stabilize the reactor pressure at a process pressure of 1 Torr. Oxygen gas is introduced through a first injector at a rate of 1 slpm. Hydrogen gas flows into the reactor through a second injector at a rate of 1 slpm. Without intending to be limited to a particular theory, singlet oxygen, hydroxyl, and ozone radicals are generated, and after 30 seconds TEOS is introduced into the reactor according to a preselected introduction curve with full flow rate of TEOS at 100 seem being obtained in 10 minutes. After maintaining the flow rates of oxygen, hydrogen and TEOS for 30 minutes, all three reactant supplies are shut off and the reactor purged for 5 minutes with dinitrogen. The reactor is backfilled to ambient pressure with dinitrogen and the wafers removed from the process chamber to cool. A silicon oxide gap fill of STI trenches on the wafer substrate is noted with a thickness of 500 nanometers with wafer-to-wafer (WTW) uniformity among 100 vertically spaced wafers within ±2 thickness percent.

### EXAMPLE 2

### TSA + NH₃ + H₂ Deposition of Silicon Nitride

The process of Example 1 is repeated with the oxygen gas flow being shut off after 30 seconds and replaced with a flow of ammonia at a rate of 1 slpm. After 30 seconds of ammonia flow, TSA is introduced instead of the TEOS of Example 1 to deposit silicon nitride with WTW uniformity of ±3% for 280 nanometer film.

### EXAMPLE 3

### TSA + Pre-excited NH₃ + H₂

The process of Example 1 is repeated with ammonia gas passing through a 5000 V electric arc discharge replacing the oxygen gas and TSA replacing the TEOS of Example 1 to deposit silicon nitride.

### EXAMPLE 4

### Sequential Deposition of Silicon Oxide and Silicon Nitride

The process of Example 1 is performed with a maintained flow time of 90 seconds and without the removal of the wafers from the reactor, the process of Example 2 is performed with a maintained flow time of 140 seconds. The resultant wafer substrates have a 20 nanometer thick layer of silicon dioxide overlayered with a 20 nanometer thick layer of silicon nitride.

### EXAMPLE 5

### HfCl₄ + O₂ + H₂ Hafnium Oxide Deposition

The procedure of Example 1 is repeated with the substitution of a like flow rate of TDMAHf for TEOS. Under the same reaction conditions, a high quality film of hafnium oxide is obtained.

Patent documents and publications mentioned in the specification are indicative of the levels of those skilled in the art to which the invention pertains. These documents and publications are incorporated herein by reference to the same extent as if each individual document or publication was specifically and individually incorporated herein by reference.

The foregoing description is illustrative of particular embodiments of the invention, but is not meant to be a limitation upon the practice thereof. The following claims, including all equivalents thereof, are intended to define the scope of the invention.

## Claims

1. A process for radical assisted film deposition simultaneously on a plurality of wafer substrates comprising:
loading the plurality of wafer substrates into a reactor, said reactor heated to a film deposition temperature ;
introducing into said reactor a stable species source of a counter ion, the counter ion selected from the group consisting of: oxide and nitride;
introducing into said reactor an *in situ* radical generating reactant; and
introducing into said reactor a cationic ion deposition source for a time sufficient to deposit a cationic ion-oxide or a cationic ion-nitride film of a thickness at the deposition temperature simultaneously on the plurality of wafer substrates.

2. The process of claim 1 wherein the deposition temperature is between 200°C and 800°C and below a chemical vapor deposition temperature absent said *in situ* radical generating reactant.

3. The process of claim 1 wherein the counter ion is oxide and said stable specie source is molecular oxygen.

4. The process of claim 1 wherein said stable species is introduced into said reactor prior to the introduction of said *in situ* radical generating reactant into said reactor.

5. The process of claim 1 wherein said cationic ion deposition source is introduced subsequent to the introduction of said stable species source into said reactor.

6. The process of claim 1 wherein said *in situ* radical, generating reactant is hydrogen.

7. The process of claim 1 wherein said counter ion is oxide and said stable species source is selected from the group consisting of molecular oxygen, carbon monoxide, nitrous oxide, water, and a combination thereof.

8. The process of claim 1 wherein said counter ion is nitride and said stable species source is selected from the group consisting of: nitrogen, ammonia, hydrazine, and a combination thereof.

9. The process of claim 1 wherein said cationic ion deposition source is a gas or vapor at the deposition temperature and comprises a silicon atom.

10. The process of claim 1 wherein said cationic ion deposition source is a gas or vapor at the deposition temperature and comprises a main group IV-VIII metal atom.

11. The process of claim 1 further comprising purging said reactor and repeating the introduction steps of introducing said stable species source, introducing said *in situ* radical generating reactant, and introducing said cationic ion deposition source with a change in concentration or identity of at least one of: said stable species source, said *in situ* radical generating reactant, and said cationic ion deposition source to deposit a second cationic ion-oxide or cationic ion-nitride film with the proviso that said multiple wafer substrates remain within said reactor between deposition of said oxide or nitride film and said second cationic ion-oxide or cationic ion-nitride film.

12. The process of claim 1 wherein the thickness of said cationic ion-oxide or cationic ion-nitride film varies among the plurality of wafer substrates to less than 5 thickness percent.

13. The process of claim 1 wherein said stable species source, said *in situ* radical generating reactant, and said cationic ion deposition source are each introduced into said reactor through an elongated vertical tube injector having vertically displaced orifices and each exits from contact with the plurality of wafer substrates through a liner surrounding said injector and having vertically displaced exhaust ports such that said cationic ion deposition source has across-flow movement simultaneously across the plurality of wafer substrates.

14. The process of claim 13 wherein each of said stable species source, said *in situ* radical generating reactant, and said cationic ion deposition source are introduced into said reactor through a separate elongated vertical tube injector having vertically displaced orifices.

15. A process for radical assisted deposition of a film containing silicon in an oxidized form simultaneously on a plurality of wafer substrates comprising:
loading a plurality of wafer substrates into a reactor;
heating said reactor to a deposition temperature;
introducing molecular oxygen into said reactor,
introducing hydrogen into said reactor to form radicals only in said reactor, and
introducing a silicon-containing precursor as a gas or vapor into said reactor for a time sufficient to deposit an oxide film of silicon of a thickness at deposition temperature less than a chemical vapor deposition temperature absent hydrogen simultaneously on the plurality of wafer substrates.

16. The process of claim 15 wherein the thickness of said cationic ion-oxide or cationic ion-nitride film varies among the plurality of wafer substrates to less than 5 thickness percent.

17. The process of claim 15 wherein said reactor affords across-flow movement of said oxygen, said hydrogen, and said silicon-containing precursor so as to uniformly deposit said oxide film on the plurality of wafer substrates at a temperature of between 400°C and 800°C.

18. The process of claim 17 wherein said oxygen, said hydrogen, and said silicon-containing precursor are each introduced into said reactor through an elongated vertical tube injector having vertically displaced orifices and each exits from contact with the plurality of wafer substrates through a liner surrounding said injector and having vertically displaced exhaust ports.

19. The process of claim 18 wherein said oxygen is introduced through said vertical tube injector and said hydrogen is introduced through a second vertical tube injector having a second injector plurality of vertically displaced orifices.

20. A plurality of wafer substrates having a cationic-ionoxidc or cationic-ion nitride film thereon formed by a process in any one of the claims 1 through 14.
